Europäisches Patentamt

European Patent Office

Office européen des brevets

(11) Veröffentlichungsnummer: **0 361 316**
**A2**

## (12) EUROPÄISCHE PATENTANMELDUNG

(21) Anmeldenummer: **89117481.5**

(22) Anmeldetag: **21.09.89**

(51) Int. Cl.5: **H01L 29/06 , H01L 29/91**

(30) Priorität: **27.09.88 DE 3832731**

(43) Veröffentlichungstag der Anmeldung:
**04.04.90 Patentblatt 90/14**

(84) Benannte Vertragsstaaten:
**DE FR GB IT**

(71) Anmelder: **Asea Brown Boveri**
**Aktiengesellschaft**
**Kallstadter Strasse 1**
**D-6800 Mannheim 31(DE)**

(72) Erfinder: **Kmitta, Hubertus**
**Bromberger Strasse 13**
**D-6944 Hemsbach(DE)**
Erfinder: **Kelberlau, Ulrich, Dr.**
**Planckstrasse 35**
**D-6840 Lampertheim(DE)**

(74) Vertreter: **Rupprecht, Klaus, Dipl.-Ing. et al**
**c/o Asea Brown Boveri Aktiengesellschaft**
**Zentralbereich Patente Postfach 100351**
**D-6800 Mannheim 1(DE)**

(54) **Leistungshalbleiterdiode.**

(57) Bei einer isolationsdiffundierten Leistungshalbleiterdiode ist die Aufgabe gestellt, unter Beibehaltung der wesentlichen elektrischen Parameter einen Aufbau anzugeben, der zu einer vereinfachten Herstellung führt.

Diese Aufgabe wird bei einer isolationsdiffundierten Leistungshalbleiterdiode dadurch gelöst, daß der pn-Übergang (10) nicht in einem Passivierungsgraben, sondern direkt an einer ersten Hauptfläche (3) der Diode austritt und dort planar mit einer Passivierungsschicht (11) abgedeckt ist.

Signifikant ist die einzige Figur der Zeichnung.

## Leistungshalbleiterdiode

Die Erfindung bezieht sich auf eine Leistungshalbleiterdiode nach dem Oberbegriff des Anspruchs 1.

Eine der wesentlichen Kenngrößen von Leistungshalbleiterdioden ist die Sperrspannung. Die Sperrspannung kann nicht höher sein als die durch Bemessung der Halbleiterzonen bestimmte Volumendurchbruchspannung; sie wird jedoch regelmäßig auf einen darunter liegenden Wert begrenzt, der von der Randkonturierung abhängt. Zur Gestaltung des Bauelementenrandes bzw. der Stelle an der Oberfläche, an der ein sperrender pn-Übergang an die Oberfläche tritt, sind mehrere Lösungen bekannt.

Zu den bekannten Techniken bzw. Gestaltungsmöglichkeiten für Randabschlüsse zählen die Mesa-Technik, der Passivierungsgraben und planare Randabschlüsse mit Hilfe von Guard-Ringen und Feldplatten. Randanschrägungen nach der Mesa-Technik und insbesondere ätztechnische Verfahren zur Herstellung von Randanschrägungen oder eines Passivierungsgrabens, dem sogenannten Moat sowie Guard-Ringe und Feldplatten sind z.B. in Ghandhi, J.K., Semiconductor Power Devices, Verlag Wiley and Sons, New York, 1977, Kap. 2 beschrieben.

Alle diese Verfahren zielen auf ein Ausdünnen der im Profil des sperrenden pn-Übergangs enthaltenen Ladungen am Rande des Bauelementes ab. Gemeinsam ist den bekannten Verfahren auch, daß sie aufwendig sind, weil z.B. hohe Anforderungen an die Maskentechnik zu stellen sind und zahlreiche Herstellungsschritte erforderlich sind. Bei der Moat-Technik sind besondere Maßnahmen erforderlich, um die bei Tiefätzung auftretenden Probleme durch Feldstärke-Überhöhung, Maskenhaftung und gleichmäßige Überdeckung mit Passivierungsglas zu lösen. Die Tiefätzung ist zur Durchtrennung des tiefliegenden pn-Übergangs erforderlich. Nachteilig ist bei den bekannten Randabschlußtechniken außerdem, daß nicht 100 Prozent der theoretisch möglichen Volumendurchbruchspannnung des Bauelements als Sperrspannung zu erreichen ist, wenn man von der Randanschrängung mit sogenanntem positiven Winkel absieht. Zudem sind Dotierungsprofile der sperrenden pn-Übergänge mit möglichst flachen Konzentrationsgradienten am pn-Übergang erforderlich, um einen hohen Anteil der Volumendurchbruchspannung zu erhalten. Dies wirkt sich negativ auf das Injektionsverhalten des pn-Übergangs aus.

Weiterhin ist beispielsweise aus der DE-AS 28 12 658 ein Verfahren zur Isolationsdiffusion bekannt, das auch mit Trenndiffusionsverfahren bezeichnet wird. Die Isolationsdiffusion hat zwar als solche keine Funktion als Randabschluß, verringert aber die Probleme des Randabschlusses, da die pn-Übergangsfläche nicht mehr am Bauelementerand austritt, sondern quasi umgelenkt wird zu der der p-Zone gegenüberliegenden Hauptfläche. Mit isolationsdiffundierten Dioden lassen sich Sperrspannungen erreichen, die 100 Prozent der Volumendurchbruchspannungen entsprechen. Die Feldstärke im gekrümmten Bereich der Isolationsdiffusion und am Austritt des pn-Übergangs in einem Passivierungsgraben ist beim isolationsdiffundierten Chip nämlich niedriger als die Feldstärke am ebenen pn-Übergang im Volumen des Chips.

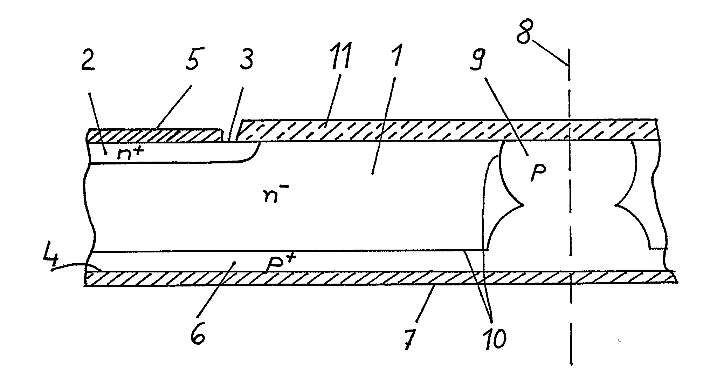

Isolationsdiffundierte Dioden sind in IEEE Transactions on Electron Devices, Vol. ED-27, No. 1, January 1980, "Analysis of a Junction Termination Structure for Ideal Breakdown Voltage in p-n Junction Devices" von T. Tanaka, Y. Mochizuki und M. Okamura, Seite 261 bis 265 dargestellt, wobei die pn-Übergangsfläche in einem Passivierungsgraben endet. In Fig. 10 der genannten Druckschrift ist eine solche Diode dargestellt und außerdem gezeigt, wie die Feldstärke am Austritt des pn-Übergangs von der Tiefe des Grabens abhängt. Durch Optimierung der Grabentiefe kann die Feldstärke minimiert werden.

Ausgehend von dem zuletzt genannten Stand der Technik liegt der Erfindung die Aufgabe zugrunde, eine isolationsdiffundierte Diode anzugeben, die mit verringertem Aufwand herstellbar ist. Diese Aufgabe wird bei einer Diode nach dem Oberbegriff des Anspruchs 1 durch dessen kennzeichnende Merkmale gelöst.

Vorteilhafte Ausgestaltungen sind in Unteransprüchen angegeben.

Mit der Erfindung wird vorgeschlagen, die Oberfläche des Bauelements lediglich mit einer Passivierungsschicht zu versehen und sonstige Maßnahmen zur Oberflächenkonturierung, wie z.B. das Ätzen eines Passivierungsgrabens, zu vermeiden. Der pn-Übergang endet somit nicht in einem Graben, sondern direkt an einer Hauptfläche. Es wurde erkannt, daß bei isolationsdiffundierten Dioden auf einen Passivierungsgraben verzichtet werden kann und trotzdem eine Sperrspannung in Höhe von 100 Prozent der Volumendurchbruchspannung erreicht wird. Die Feldstärke am Ort des Austritts des sperrenden pn-Übergangs aus der Oberfläche ist zwar etwas höher als beim Austritt in einem Graben, jedoch deutlich niedriger als im Volumen und ohne weiteres mit bekannten bei nicht-isolationsdiffundierten Bauelementen benutzten Passivierungstechniken beherrschbar. Geeignet ist z.B. eine Passivierung mit Passivierungsglas oder einer Schichtenfolge aus z.B. Siliziumoxid, Phosphor-Silika-Glas und Siliziumnitrid, die nach einem CVD-Verfahren aufgebracht werden kann. Die vorgeschlagene Vermeidung des bisher bei solchen Leistungshalbleiterdioden für erforderlich gehaltenen Passivierungsgrabens bedeutet eine erhebliche Vereinfachung der Herstellung, da einige Schritte zur Maskierung und Ätzung entfallen und Qualitätsprobleme durch mangelhafte Kantenbedeckung eines Grabens mit der Passivierungsschicht nicht auftreten können.

Ein Ausführungsbeispiel ist in der Zeichnung dargestellt und wird nachstehend beschrieben.

Die Zeichnung zeigt einen Querschnitt durch den Randbereich einer Siliziumleistungshalbleiterdiode. Die Diode besteht aus einem n-dotierten Substrat 1 mit einer ersten Hauptfläche 3 und einer zweiten Hauptfläche 4. Die erste Hauptfläche 3 ist in einem Randbereich der Diode die Oberfläche der n-leitenden Schicht, also des n-dotierten Substrats 1, und in einem großen mittleren Bereich die Oberfläche eines Kathodenbereichs 2 mit verstärkter n-Dotierung. Über diesem mit $n^+$ bezeichneten Kathodenbereich 2 ist eine Kathodenmetallisierung 5 angeordnet.

Die zweite Hauptfläche 4 ist die Oberfläche einer mit $p^+$ bezeichneten p-leitenden Schicht 6, auf der eine Anodenmetallisierung 7 aufgebracht ist. Die Herstellung von Dioden der dargestellten Art erfolgt regelmäßig so, daß eine größere Siliziumscheibe verwendet wird und gleichzeitig mehrere Dioden hergestellt werden. Eine eingezeichnete Trennlinie 8 gibt die Stelle an, an der die Siliziumscheibe getrennt wird zur Herstellung einzelner Diodenchips. Die Trennlinie 8 führt mitten durch eine durch Isolationsdiffusion hergestellte p-dotierte Randzone 9, die nach der Teilung der Siliziumscheibe den Diodenrand bildet. Ein durch die aneinandergrenzenden n-und p-Schichten gebildeter pn-Übergang 10 tritt somit nicht am Chiprand an die Oberfläche, sondern an der ersten Hauptfläche 3. Die Austrittsstelle des pn-Übergangs 10 ist durch eine Passivierungsschicht 11, z.B. aus Passivierungsglas, abgedeckt.

Die Herstellung der in der Zeichnung dargestellten Leistungshalbleiterdiode kann nach unterschiedlichen bekannten Verfahren erfolgen.

## Ansprüche

1. Leistungshalbleiterdiode mit
- einer ersten und einer zweiten Hauptfläche,
- einer an die erste Hauptfläche angrenzenden Schicht eines ersten z.B. p-leitenden Typs und einer an die zweite Hauptfläche angrenzenden Schicht eines zweiten z.B. n-leitenden Typs,
- eine durch Isolationsdiffusion hergestellte Zone des ersten Leitungstyps, die die Diode längs ihres Randes abschließt, und
- einem pn-Übergang zwischen der Schicht des zweiten Leitfähigkeitstyps und der Schicht sowie der Randzone des ersten Leitfähigkeitstyps, dadurch gekennzeichnet, daß der pn-Übergang (10) direkt an der ersten Hauptfläche (3) an die Oberfläche tritt und planar durch eine Passivierungsschicht (11) abgedeckt ist.

2. Leistungshalbleiterdiode nach Anspruch 1, dadurch gekennzeichnet, daß als Passivierungsschicht (11) ein Passivierungsglas verwendet ist.

3. Leistungshalbleiterdiode nach Anspruch 1, dadurch gekennzeichnet, daß als Passivierungsschicht (11) eine aus mehreren Einzelschichten zusammengesetzte Schicht vorgesehen ist.

4. Leistungshalbleiterdiode nach Anspruch 3, dadurch gekennzeichnet, daß die zusammengesetzte Schicht aus Siliziumoxid, Phosphor-Silika-Glas und Siliziumnitrid besteht und vorzugsweise durch CVD-Verfahren aufgebracht wird.